Europäisches Patentamt

European Patent Office

Office européen des brevets

(19)

(11) **EP 1 271 501 A2**

(12) **EUROPÄISCHE PATENTANMELDUNG**

(43) Veröffentlichungstag:
**02.01.2003 Patentblatt 2003/01**

(51) Int Cl.7: **G11B 7/24**

(21) Anmeldenummer: **02020133.1**

(22) Anmeldetag: **13.09.1999**

(84) Benannte Vertragsstaaten:
**AT BE CH CY DE DK ES FI FR GB GR IE IT LI LU MC NL PT SE**

(30) Priorität: **02.10.1998 CH 200998**
**24.12.1998 CH 256398**

(62) Dokumentnummer(n) der früheren Anmeldung(en) nach Art. 76 EPÜ:
**99941355.2 / 1 119 848**

(71) Anmelder: **Unaxis Balzers Aktiengesellschaft**
**9496 Balzers (LI)**

(72) Erfinder:
• **Dubs, Martin**
**7304 Maienfeld (CH)**
• **Weinzerl, Helfried**
**6800 Feldkirch (AT)**

(74) Vertreter: **Troesch Scheidegger Werner AG**
**Patentanwälte**
**Postfach**
**8032 Zürich (CH)**

Bemerkungen:
This application was filed on 09 - 09 - 2002 as a divisional application to the application mentioned under INID code 62.

(54) **Optische Datenspeicherscheibe**

(57) Eine optische Speicherscheibe weist, in Richtung ihrer Dickenausdehnung (d) betrachtet, zwei Grenzflächen auf. An der einen ist eine reflektierende Schicht ($L_1$), an der andern eine teilreflektierende, teiltransmittierende Schicht ($L_0$) vorgesehen. Beide Schichten ($L_1$, $L_0$) bestehen aus jeweiligen Metallegierungen, woran ein oder mehrere gleiche Metalle enthalten sind. Enthalten die Legierungen Gold, so nur zu einem Anteil von höchstens 50 at% der jeweiligen Legierung.

FIG.1

**EP 1 271 501 A2**

Printed by Jouve, 75001 PARIS (FR)

**Beschreibung**

Die vorliegende Erfindung betrifft eine optische Datenspeicherscheibe, bei der, von einer Scheibenoberfläche in Richtung der Scheibendickenausdehnung fortschreitend, mindestens zwei Grenzflächen vorgesehen sind, welche je, entsprechend gespeicherter Information, profiliert sind und wobei die zuinnerst gelegene, profilierte Grenzfläche eine Reflexionsschicht, die mindestens eine, weitere profilierte Grenzfläche eine teilreflektierende/teiltransmittierende Schicht aufweist, je für Licht gegebener Wellenlänge und unter gleichen Einfallswinkeln < 90°, wobei weiter das übrige Scheibenmaterial zwischen der Oberfläche und der Reflexionsschicht das erwähnte Licht im wesentlichen transmittiert, wobei die Reflexionsschicht aus einer ersten Metalllegierung, die Teilreflexionsschicht aus einer zweiten Metalllegierung besteht.

Eine derartige Datenspeicherscheibe ist aus der US-A-5 640 382 bekannt. Von der einen Scheibenoberfläche in Richtung der Scheibendickenausdehnung fortschreitend, weist sie erst ein transparentes Substrat auf, dann eine teilreflektierende Schicht auf einer ersten informationsprofilierten Grenzfläche, dann eine transmittierende Abstandsschicht und schliesslich eine hochreflektierende Schicht auf einer zweiten informationsprofilierten Grenzschicht.

Das erstgenannte transparente Substrat kann dabei aus einem Polymermaterial sein, wie beispielsweise Polycarbonat oder aus amorphem Polyolefin. Anderseits sei es auch möglich, hierfür Glas oder ein Polymethylmetacrylat einzusetzen. Bekanntlich (a.a.O.) kann dieses Substrat auch aus PMMA bestehen.

Die Abstandhalteschicht besteht weiter beispielsweise aus einem Polymer. Die hochreflektierende Schicht für Laserlicht zwischen 600 und 850 nm wird aus Aluminium, Gold, Silber, Kupfer oder einer ihrer Legierungen gebildet. Der Wellenlängenbereich des Laserlichtes kann, wie andernorts erwähnt, bis 500 nm reichen.

Bevorzugt wird gemäss der erwähnten US-PS für die teilreflektierende Schicht Gold eingesetzt, aufgrund seiner optischen Eigenschaften und insbesondere seiner Stabilität gegenüber Umwelteinflüssen. Es wird allerdings erkannt, dass Gold teuer ist. Deshalb wird für die erwähnte teilreflektierende Schicht weiter vorgeschlagen, Gold mit einem weniger teuren Metall zu legieren, um die Kosten zu reduzieren. Dabei wird an der Legierung der teilreflektierenden Schicht mindestens 10 at% Gold, bevorzugt bis 20 at% Gold, beibehalten, um die Stabilität gegenüber Umwelteinflüssen aufrechtzuerhalten.

Als Goldlegierungsmetall wird Silber oder Kupfer vorgeschlagen.

Die US-5 640 382 wird bezüglich Aufbau eines optischen Datenspeichers, von dem die vorliegende Erfindung ausgeht, als integrierter Bestandteil der vorliegenden Erfindung eingeführt.

Bei solchen optischen Datenspeicherscheiben, ausgebildet z.B. als DVD9, Digital Versatile Disk, gemäss Definitionen im DVD-Standard "DVD Specifications for Read-Only Disks", Version 1.0 of August 1966, wird gefordert, dass bei einer gegebenen Wellenlänge von Laserlicht, insbesondere bei 650 nm, das aufgrund der Reflexionen sowohl an der teilreflektierenden Schicht wie auch an der reflektierenden Schicht wieder austretende Laserlicht je 18 bis 30 % des vom Laser eingestrahlten Lichtes betragen müssen. Als DVD9 wird heute verstanden eine "single sided dual layer disc."

Es ist Aufgabe der vorliegenden Erfindung, eine optische Datenspeicherscheibe obgenannter Art vorzuschlagen, welche

- diese Spezifikationen bezüglich Strahlaufteilung einhält,

- in der Fertigung jedoch wesentlich kostengünstiger ist und

- deren Schichten eine chemische Beständigkeit gegenüber Umwelteinflüssen aufweisen, wie z.B. bezüglich Korrosion, welche Anforderungen in ähnlichem Masse wie vorbekannte Datenspeicherscheiben erfüllen.

Diese Aufgabe wird an der erwähnten Datenspeicherscheibe dadurch gelöst, dass

- die Legierungen der mindestens zwei Schichten ein oder mehrere gleiche Metall(e) enthalten, wobei das eine oder die mehreren Metall(e) gemeinsam einen Anteil von mehr als 50 at% der jeweiligen Legierung ausmachen,

- falls die Legierungen Gold enthalten, dies nur zu einem Anteil von höchstens 50 at% der jeweiligen Legierung.

Dadurch, dass die Legierung ein oder mehrere gleiche Metall(e) enthält, mit einem Anteil an der jeweiligen Legierung von mehr als 50 at% wird es möglich, mindestens für diesen jeweiligen Legierungsteil dieselbe Beschichtungsquellenanordnung einzusetzen. Dadurch wird die Basis geschaffen, den Fertigungsprozess für die erwähnten Datenscheiben wesentlich zu rationalisieren. Dadurch, dass weiter, wenn überhaupt Gold an der einen und/oder andern der Legierungen vorgesehen wird, dies nur mit einem Anteil von höchstens 50 at% des Legierungsmaterials erfolgt, wird weiter erreicht, dass auch aufgrund der Kosten für die verwendeten Legierungsmaterialien selber die erfindungsgemässe Scheibe in der Fertigung kostengünstig wird.

Obwohl es durchaus möglich ist, die erwähnten mehreren gleichen Metalle, welche einen Anteil > 50 at% am jeweiligen Legierungsmaterial bilden, schichtspezifisch mit unterschiedlichen Anteilen vorzusehen, wird in einer bevorzugten Ausführungsform vorgeschlagen, die erwähnten gleichen Metalle an den Legierungen mit gleichen Anteilen vorzusehen, dabei vorzugsweise auch den Anteil der Gesamtheit dieser gleichen Metalle am Legierungsmaterial gleich auszubilden.

Dadurch wird ermöglicht, eine Beschichtungsquellenanordnung für die erwähnten gleichen Metalle schichtunspezifisch bei Ablegen beider Schichten gleich zu betreiben.

In einer weiteren bevorzugten Ausführungsform wird weiter vorgeschlagen, dass die Legierungen als Ganzes durch gleiche Metalle, dabei vorzugsweise mit denselben Legierungsanteilen, gebildet sind. Dabei können selbstverständlich weitere Elemente wie N, O, Ar in Spuren enthalten sein. Damit können die Schichten anschliessend mittels der gleichen Beschichtungsquellenanordnung abgelegt werden.

In einer ersten, besonders bevorzugten Ausführungsform der erfindungsgemässen Datenspeicherscheibe sind die erwähnten gemeinsamen, je mehr als 50 at% der jeweiligen Legierungsmaterialien ausmachenden Metalle bzw. bestehen, insbesondere bevorzugt, die Legierung als Ganzes aus

$$Ag_x Ma_y Mb_z$$

oder aus

$$Cu_x Ma_y Mb_z$$

mit x > 50 %, wobei x, schichtspezifisch, im angegebenen Rahmen durchaus variieren kann. Es bezeichnen Ma und Mb ein Zweit- bzw. Drittmetall.

Weiter wird in einer besonders bevorzugten Ausführungsform, insbesondere bei Einsatz von $Ag_x Ma_y Mb_z$, vorgeschlagen, als Zweitmetall Ma Palladium einzusetzen mit y > z, d.h. mit einem höheren Anteil als ein ggf. vorgesehenes Drittmetall Mb. Es sei darauf hingewiesen, dass alle in vorliegender Beschreibung sowie den Ansprüchen aufgeführten Grössenangaben für x, y, z sich als at% von 100 at% Schichtmaterial-Legierung verstehen.

Dabei wird weiter vorgeschlagen, dass gilt:

$$0 < y \leq 10, \text{ bevorzugt } 1 \leq y < 10$$

und

$$0 < z \leq 10, \text{ bevorzugt } 1 \leq z < 10.$$

was besagt, dass wenn die obgenannten Legierungen aus den erwähnten drei Metallen bestehen, sich jeweils für Ag bzw. Cu ergibt:

$$x = 100 - y - z.$$

In einer weiteren bevorzugten Ausführungsform ohne Drittmetall gilt:

$$0 < y \leq 15, \text{ bevorzugt } 1 \leq y < 15$$

und

$$z \approx 0,$$

was zu Silber-Palladium-Legierungsschichten und/oder Cu-Palladium-Schichten führt, Silber-Palladium-Schichten dabei klar bevorzugt.

Dabei wird weiter vorgeschlagen, dass gilt:

$$5 \leq y \leq 10, \text{ bevorzugt } 5 < y < 10$$

und

$$z \approx 0,$$

was insbesondere bei Silberlegierungsschichten mit Palladium, bevorzugt bei Schichten ausschliesslich aus der Silber-Palladium-Legierung, bevorzugt ist.

Insbesondere hierfür, nämlich für den Einsatz von Silber-Palladium-Legierungen wird vorgeschlagen zu wählen:

$$y = 8 \text{ und } z \approx 0.$$

Obwohl die angegebenen Werte auch für

$$Cu_x, Ma_y, Mb_z$$

bevorzugt gelten, insbesondere auch für Kupfer-Palladium-Legierungen, wird weitaus bevorzugt je eine Silber-Palladium-Legierung oder eine Legierung, die jeweils Silber und Palladium zu mehr als 50 at% Anteil umfasst, eingesetzt.

Als das oben angegebene Zweit- oder Drittmetall Ma bzw. Mb, insbesondere als Ma, in diesem Fall anstelle des oben angegebenen bevorzugten Palladiums, kann auch Gold eingesetzt werden mit

$$y > z.$$

Wird für die erwähnten mindestens zwei Schichten dieselbe Legierung eingesetzt und mithin der Brechungsindex beider Legitierungen mit n, der Absorptionskoeffizient mit k bezeichnet, so gilt bevorzugterweise

$$0 < n/k \leq 0{,}28,$$

besonders bevorzugt

$$0 < n/k \leq 0{,}20.$$

Dies gilt bei Licht mit $\lambda = 650$ nm und dem Schichtmaterial in Bulkform vorliegend. Dabei entsprechen die Verhältnisse an der Reflexionsschicht aufgrund ihrer Dicke weitestgehend den Verhältnissen am Bulk. Im weiteren gilt für jede Metalllegierung $k > 2$.

In einer weiteren bevorzugten Ausführungsform der erfindungsgemässen Datenspeicherscheibe ist die Stabilität der optischen Eigenschaften, insbesondere der Schichten, also Reflexion, Transmission, Absorption, besser als $\pm 2$ %, vorzugsweise gar besser als $\pm 1$ %, wenn während 24 h Luft ausgesetzt.

Ein erfindungsgemässes Herstellungsverfahren zeichnet sich nach dem Wortlaut von Anspruch 11 aus, eine bevorzugte Ausführungsvariante nach Anspruch 12, ein erfindungsgemässes Target nach Anspruch 17.

Im weiteren wird die obgenannte Aufgabe bezüglich Spezifikationen, kostengünstige Fertigung und chemische Beständigkeit auch bereits dadurch gelöst, dass, abgesehen von der Ausbildung der Reflexionsschicht, die teilreflektierende Schicht aus

$$Ag_x Ma_y Mb_z$$

besteht, oder aus

$$Cu_x Ma_y Mb_z$$

mit $x > 50$ %, wobei bezeichnen:

Ma: ein Zweitmetall, ausser Gold

Mb: ein Drittmetall, bevorzugt ausser Gold.

Damit ist es möglich, auch bei Ausbildung der Reflexionsschicht beispielsweise aus einer Aluminiumlegierung, grundsätzlich grosse Kosteneinsparungen zu erwirken, verglichen mit dem Ablegen vorbekannter Legierungen für die teilreflektierende Schicht.

In einer bevorzugten Ausführungsform besteht die teilreflektierende Schicht aus $Ag_x Ma_y Mb_z$, und als Zweitmetall Ma ist Palladium eingesetzt. Dabei gilt $y > z$.

Im weiteren gilt bevorzugt an der teilreflektierenden Schicht:

$$0 < y \leq 10, \text{ bevorzugt } 1 \leq y < 10$$

und

$$0 < z \leq 10, \text{ bevorzugt } 1 \leq z < 10.$$

Anderseits gilt in einer weiteren bevorzugten Ausführungsform bezüglich der teilreflektierenden Schicht:

$$0 < y \leq 15, \text{ bevorzugt } 1 \leq y < 15,$$

$$z \approx 0$$

und dabei bevorzugt

$$5 \leq y < 10, \text{ insbesondere bevorzugt } 5 < y < 10,$$

weiterhin mit

$$z \approx 0.$$

In einer heute besonders bevorzugten, insbesondere aus der AgPd-Legierung bestehenden, teilreflektierenden Schicht gilt:

$$y = 8$$

$$z \approx 0.$$

Es wird dabei auf die nachfolgend erläuterte und dargelegte hohe Umweltstabilität der erwähnten Legierungen, insbesondere der AgPd-Legierung, als Teilreflexionsschicht eingesetzt, verwiesen.

Die Erfindung wird anschliessend beispielsweise anhand von Figuren erläutert. Es zeigen:

Fig. 1     schematisch einen Querschnitt durch eine optische Datenspeicherscheibe mit Doppelinformationsträger-Grenzfläche,

Fig. 2     einen Verlauf der Absorption in Funktion des Verhältnisses n/k von Schichtmaterial,

Fig. 3a     bei einer bevorzugten Ausführungsform einer erfindungsgemässen optischen Datenspeicherscheibe, die an den teilreflektierenden Schichten unmittelbar nach ihrer Fertigung gemessenen Absorptions-, Transmissions- und Reflexionsverhältnisse,

Fig. 3b    in Darstellung analog zu Fig. 2a, die erwähnten Verhältnisse nach 13 Std. Luftlagerung,

Fig. 3c    in Darstellung analog zu den Fig. 2a und 2b die erwähnten Verhältnisse nach 37,5 Std. Luftlagerung.

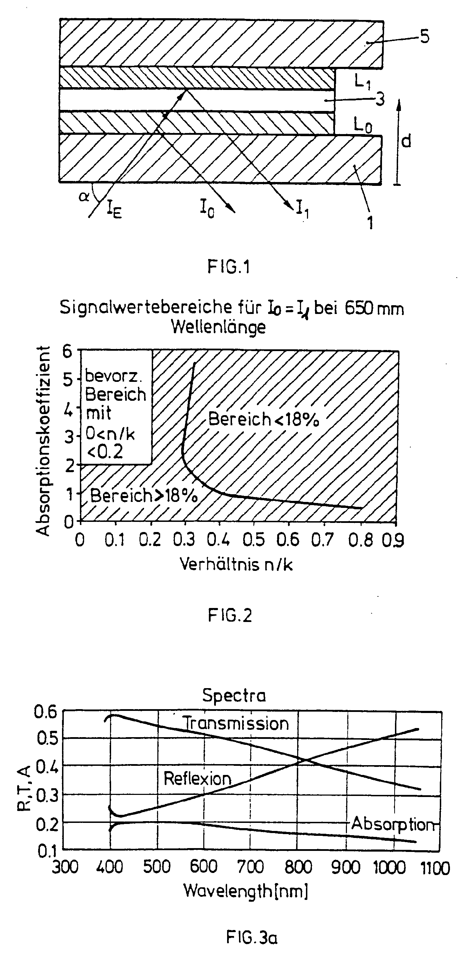

In Fig. 1 ist schematisch eine optische Datenspeicherscheibe der in vorliegender Anmeldung angesprochenen Art dargestellt. Sie umfasst, in Richtung d von einer der Scheibenflächen ausgehend nach innen fortschreitend, ein insbesondere für Licht mit $\lambda = 650$ nm transparentes Substrat 1, vorzugsweise aus Polycarbonat, dem sich eine teilreflektierende, teiltransmitierende Schicht $L_0$ anschliesst. Es folgt eine Abstandshalteschicht 3, beispielsweise eine Klebeschicht, ebenfalls insbesondere für das erwähnte Licht transmittierend, sowie eine reflektierende Schicht $L_1$, alles auf einem Träger 5, wie beispielsweise wiederum aus Polycarbonat. An den Grenzflächen 1/3 und 3/5 je mit vorgesehener Schicht $L_0$, $L_1$ sind die Informations-Prägemuster vorgesehen.

Laserlicht $I_E$ mit 500 nm $\leq \lambda \leq 8580$ nm, vorzugsweise mit $\lambda = 650$ nm, wird unter einem Winkel $\alpha <$ 90° auf die Speicherscheibe gerichtet und wird an der teilreflektierenden Schicht $L_0$ teilreflektiert, um mit dem Anteil $I_0$ wieder auszutreten. An $L_0$ teiltransmittiertes Licht wird an der reflektierenden Schicht $L_1$ weitestgehend vollreflektiert und tritt mit dem Anteil $I_1$ aus.

Wird gemäss einer weitaus bevorzugten Ausführungsform der vorliegenden Erfindung vorausgesetzt, dass die Metalllegierungen der Schichten $L_1$ und $L_0$ gleich sind, so kann für beide Legierungen der Brechungsindex zu näherungsweise n und der Absorptionskoeffizient zu k gesetzt werden. Dabei ist der Absorptionskoeffizient k für Metalle bzw. Metalllegierungen üblicherweise k > 2.

In Fig. 2 ist der Verlauf des Absorptionskoeffizienten in Funktion des Verhältnisses n/k wie gerechnet aufgetragen. Dabei wurde davon ausgegangen, dass die Signale $I_0$ und $I_1$ perfekt ausbalanciert sind, weiter die Reflexionsverteilung über die Disc-Scheibe perfekt ist ($\pm$ 0 %) sowie keine weiteren Verluste auftreten. Es ist aus Fig. 2 ersichtlich, dass ein n/k-Verhältnis einzuhalten ist, für welches gilt:

$$0 < n/k \leq 0,28,$$

dabei bevorzugt

$$0 < n/k \leq 0,20,$$

damit die Signalwerte grösser als 18 % werden können.

Dabei gilt der in Fig. 2 gezeigte Verlauf weiter für Licht mit einer Wellenlänge $\lambda = 650$ nm sowie für Bulkmaterial. Die Verhältnisse an der Reflexionsschicht $L_1$ gemäss Fig. 1 entsprechen weitgehendst den optischen Verhältnissen am Bulkmaterial.

Real ist mit folgenden Einflüssen zu rechnen:

Signalverluste von 5 bis 10 %, beispielsweise durch Doppelbrechung im Substrat 1, Streuungsverluste durch die Informationseinprägemuster,

Reproduzierbarkeit der Reflexion, Reflexionsverteilung entlang dem Disk, welche $\pm$ 1 % bzw. $\pm$ 1,5 % betragen dürften. Das an Bulkverhältnissen gerechnete Signal, weitestgehend $I_1$ von Fig. 1 entsprechend, soll grösser als 22 bis 23 % $I_E$ sein, damit, in einer industriellen Massenproduktion, das Signal weiterhin > 18 % bleibt. Für diese industrielle Produktion ist mithin bevorzugt von

$$0 < n/k \leq 0,2$$

auszugehen, um geringstmöglichen Ausschuss zu gewährleisten.

Bei der Legierungsauswahl, bevorzugt für gleiche Legierungen mit gleichen Metallanteilen an beiden Schichten $L_0$, $L_1$, ergeben sich unter Einhalt der geforderten chemischen Beständigkeit sowie möglichst geringer Goldanteile vorerst folgende Legierungen als Universalschichtmaterialien:

• Silber-Palladium-Legierungen

Es wurde durch DC-Sputtern eines Silber-Palladium-Legierungstargets $Ag_{92}Pd_8$-Schichten abgelegt. Als Reflexionsschicht $L_1$ wurde die Legierungsschicht mit einer Dicke > 60 nm, bevorzugt > 75 nm abgelegt. Gesputtert wurde mit einer Aufwachsrate von 13 nm/kWsec. Die optischen Werte entsprechen weitestgehend den optischen Werten der Silber-Palladium-Legierung als Bulk. Folgende Werte wurden gemessen:

| Reflexion | 90 % |
|---|---|
| Absorption | 10 % |
| n | 0,511 |
| k | 3,74 |
| n/k | 0,136 |

Aus diesen Werten ist ersichtlich, dass für die vorerwähnte Silber-Palladium-Legierung ein n/k-Wert von 0,136 resultiert. Für die ermittelten Werte am Bulkmaterial kann nun rechnerisch eine geeignete Schichtdicke von 13 bis 17 nm für die teilreflektierende Schicht gemäss $L_0$ von Fig. 1 ermittelt werden.

Für eine solche teilreflektierende Schicht ergab sich das in Fig. 3a wiedergegebene optische Verhalten bezüglich Transmission, Reflexion und Absorption, dies unmittelbar nach ihrer Fertigung.

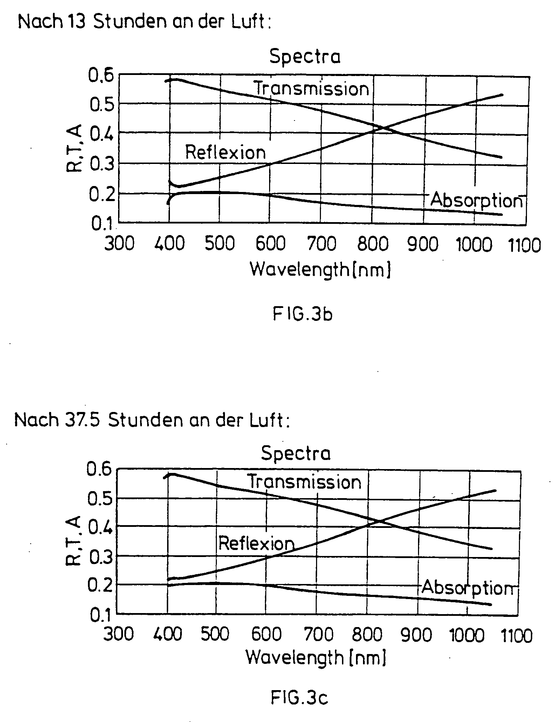

Nach 13 Std. ergaben sich Verläufe nach Fig. 3b und schliesslich, nach 37,5 Std. Luftlagerung gemäss Fig. 3c.

Daraus lässt sich folgern, dass erfindungsgemäss vorgesehene Schichten äusserst stabil realisiert werden können, mit einer Stabilität ihrer optischen Eigenschaften, nämlich von Reflexion, Transmission und Absorption im gesamten erfassten Bereich von 500 bis 900 nm von besser als $\pm$ 2 %, wenn sie mindestens 24 h an Luft gelagert werden. Die besonders bevorzugte Silber-Palladium-Legierung ergibt gemäss den angeführten Figuren eine Stabilität gar besser als $\pm$ 1 %.

Dieses Material kann durch einen herkömmlichen DC-Sputterprozess mit sehr hoher Rate abgelegt werden. Verglichen mit einer Goldbeschichtung liegen die Kosten einer Silber-Palladium-Beschichtung ca. 80 % bis 90 % tiefer.

Somit ist mit der erwähnten Silber-Palladium-Legierung ein Universalmaterial für Schichten an optischen Datenscheiben obgenannter Art gefunden.

Weitere Silber-Palladium-Legierungen $Ag_xPd_y$ mit Legierungsanteilen y von Palladium $0 < y \leq 15$, bevorzugt von $1 \leq y < 15$ und mithin x = 100 - y lassen sich mit ähnlich guten Resultaten einsetzen, ebenso wie Legierungen $Ag_xPd_yMb_z$ mit $0 < y \leq 10$, bevorzugt von $1 \leq y < 10$ und $0 < z \leq 10$, bevorzugt $1 \leq z < 10$. $M_b$ kann dabei beispielsweise Gold sein.

Nachdem durch Experimente an Silber-Palladium-Legierungen die Gesetzmässigkeiten und die Machbarkeit der Lösung der der vorliegenden Erfindung zugrundegelegten Aufgabe aufgefunden wurde, ergibt sich, dass beispielsweise auch Silber-Gold-Legierungen sich für beide Schichten als Universalmaterialien eignen, weist doch eine $Ag_{60}Au_{40}$-Legierung einen n/k-Wert von 0,079 und eine $Ag_{50}Au_{50}$-Legierung einen n/k-Wert von 0,108 auf.

Es können alle Legierungen $Ag_xAu_y$ mit $0 < y < 50$, bevorzugt mit $1 \leq y < 50$ und mithin x = 100 - y bzw. Legierungen $Ag_xAu_yMb_z$ mit $x > 50$, $0 < y < 50$, bevorzugt $1 \leq y < 50$, $0 < z \leq 10$, bevorzugt $1 \leq z < 10$ und mithin x = 100 - y - z als Universalmaterialien in Betracht gezogen werden.

Auch Kupfer-Gold-Legierungen zeigten sich für Universalmaterial geeignet:

$Cu_{50}Au_{50}$-Legierungen haben n/k-Werte von 0,142,

$Cu_{60}Au_{40}$ von 0,156.

Generell können alle Legierungen $Cu_xAu_y$ mit $0 < y < 50$, bevorzugt $1 \leq y < 50$ und mithin x = 100 - y bzw.
Legierungen $Cu_xAu_yMb_z$ mit $x > 50$, $0 < y < 50$, bevorzugt $1 \leq y < 50$ und $0 < z \leq 10$, bevorzugt $1 \leq z < 10$ und mithin x = 100 - y - z als Universalmaterialien eingesetzt werden.

Dies gilt auch für Kupfer-Zinn-Legierungen (Bronzen) sowie für Kupfer-Palladium-Legierungen.

Bei der Herstellung der optischen Datenspeicherscheiben wird für alle Schichten eine Hauptbeschichtungsquelle eingesetzt, bevorzugt sogar nur eine Beschichtunsgsquelle für alle Schichten. Hierzu eignet sich besonders eine DC-Sputterquelle, wie DC-Magnetronquelle, mit dem vorgesehenen Legierungsanteil als Targetmaterial. Ggf. von Schicht zu Schicht variierende Metallanteile können an diesen Quellen durch unterschiedliche Prozessführung eingestellt werden. Im weiteren kann beim Ablegen der Schichten ein äusserst geringer Substrat/Quellenabstand eingehalten werden, und das Substrat kann bezüglich der Quelle stationär beschichtet werden, was gesamthaft zu kompakten, kostengünstigen Herstellungsanlagen führt.

Bezüglich der besonders bevorzugten Silber-Palladium-Legierung kann weiter ausgeführt werden, dass diese gegenüber Umwelteinflüssen ganz besonders stabil ist und bei ihrer Herstellung mit einem hohen Sputter-Yield ablegbar ist.

Die vorgeschlagenen Universalmaterialien sind wesentlich billiger als Gold. Aufgrund der Merkmale, mindestens einen Grundlegierungsanteil an beiden Schichten aus den gleichen Metallen zu bilden, bevorzugt die Schichten aus gleichen Legierungen zu fertigen, ist es möglich, die erfindungsgemässen Datenspeicherscheiben an einer einzigen Beschichtungsanlage, insbesondere Sputteranlage, vorzugsweise durch Einsatz einer einzigen Quelle zu realisieren.

## Patentansprüche

1. Optische Datenspeicherscheibe, bei der, von einer Scheibenoberfläche in Richtung der Scheibendickenausdehnung fortschreitend, mindestens zwei Grenzflächen vorgesehen sind, welche je, entsprechend gespeicherter Information, profiliert sind und wobei die zuinnerst gelegene, profilierte Grenzfläche eine Reflexionsschicht, die mindestens eine, weitere profilierte Grenzfläche eine teilreflektierende/teiltransmittierende Schicht aufweist, je für Licht gegebener Wellenlänge und unter gleichen Einfallswinkeln < 90°, wobei weiter das übrige Scheibenmaterial zwischen der Oberfläche und der Reflexionsschicht das erwähnte Licht im wesentlich transmittiert, und weiter die Reflexionsschicht aus einer ersten Metalllegierung, die Teilreflexionsschicht aus einer zweiten Metalllegierung bestehen, **dadurch gekennzeichnet, dass** die Metalllegierung der teilreflektierenden Schicht besteht aus:

$$Ag_xMa_yMb_z$$

oder aus

$$Cu_xMa_yMb_z$$

mit x > 50 %, wobei bezeichnen

Ma:    ein Zweitmetall, ausser Gold

Mb:    ein Drittmetal, vorzugsweise ausser Gold

2.  Datenspeicherscheibe nach Anspruch 1, **dadurch gekennzeichnet, dass** die teilreflektierende Schicht aus

$$Ag_xMa_yMb_z$$

besteht und das Zweitmetall Palladium ist, mit y > z.

3.  Datenspeicherscheibe nach einem der Ansprüche 1 oder 2, **dadurch gekennzeichnet, dass** gilt:

$$0 < y \leq 10, \text{ bevorzugt } 1 \leq y < 10,$$

$$0 < z \leq 10, \text{ bevorzugt } 1 \leq z < 10.$$

4.  Datenspeicherscheibe nach einem der Ansprüche 1 bis 3, **dadurch gekennzeichnet, dass** gilt:

$$0 < y \leq 15, \text{ bevorzugt } 1 \leq y < 15,$$

$$z \approx 0, \text{ vorzugsweise}$$

$$5 \leq y \leq 10, \text{ insbesondere } 5 < y < 10,$$

$$z \approx 0,$$

dabei insbesondere bevorzugt

$$y = 8$$

$$z \approx 0,$$

insbesondere für eine AgPd-Legierungsschicht.

5.  Target, bestehend aus einer Legierung

$$Ag_xMa_yMb_z$$

oder aus

$$Cu_xMa_yMb_z$$

mit

$$x > 50 \text{ at\%,}$$

wobei bezeichnen

Ma:    ein Zweitmetall

Mb:    ein Drittmetall.

6.  Target nach Anspruch 5, **dadurch gekennzeichnet, dass** das Target besteht aus

$$Ag_xMa_yMb_z$$

und
Ma Palladium ist, mit y > z.

7.  Target nach Anspruch 5 oder 6, **dadurch gekennzeichnet, dass** gilt:

$$0 < y \leq 10, \text{ dabei bevorzugt } 1 \leq y < 10$$

und

$$0 < z \leq 10, \text{ bevorzugt } 1 \leq z < 10.$$

8.  Target nach einem der Ansprüche 5 bis 7, insbesondere bevorzugt aus $Ag_xPd_y$, **dadurch gekennzeichnet, dass** gilt

$$0 < y \leq 15,$$

bevorzugt

$$1 \leq y < 15$$

und

$$z \approx 0,$$

dabei bevorzugt gilt:

$$5 \leq y \leq 10, \text{ bevorzugt } 5 < y < 10$$

und

$$z \approx 0,$$

insbesondere bevorzugt gilt:

$$y = 8, z \approx 0.$$

9. Target nach einem der Ansprüche 5 bis 8, **dadurch gekennzeichnet, dass** gilt:

$$Ma = Au, \text{ mit } y > z.$$

10. Target nach einem der Ansprüche 5 bis 9, **dadurch gekennzeichnet, dass** für das Verhältnis von Brechungsindex zu Absorptionskoeffizienten n/k an der Legierung als Bulk und bei Licht von 650 nm gilt:

$$0 < n/k \leq 0{,}28,$$

vorzugsweise

$$0 < n/k \leq 0{,}2.$$

FIG.1

Signalwertebereiche für $I_0 = I_1$ bei 650 mm Wellenlänge

FIG.2

Spectra

FIG.3a

Nach 13 Stunden an der Luft:

FIG.3b

Nach 37.5 Stunden an der Luft:

FIG.3c